# EUROPEAN PATENT SPECIFICATION

(11) **EP 3 204 446 B1**
(45) Date of publication and mention of the grant of the patent: **17.06.2020**
(21) Application number: 15849412.0
(22) Date of filing: 05.10.2015
(51) Int. Cl.: C08J 7/04, C08K 3/22, C08L 81/02, C08L 101/12

(54) **THERMALLY CONDUCTIVE POLYMER ARTICLES FOR ELECTRONIC CIRCUITRY**
WÄRMELEITENDE POLYMERARTIKEL FÜR ELEKTRONISCHE SCHALTUNGEN
ARTICLES POLYMÈRES THERMOCONDUCTEURS POUR CIRCUITS ÉLECTRONIQUES

(30) Priority: 07.10.2014 US 201462060707 P
(43) Date of publication of application: 16.08.2017
(73) Proprietor: PolyOne Corporation, Avon Lake, OH 44012 (US)
(72) Inventor: CHABANNE, Philippe, F-21000 Dijon (FR); MAURER, Renaud, F-21420 Pernand-Vergelesses (FR)
(74) Representative: Winter, Brandl, Fürniss, Hübner, Röss, Kaiser, Polte - Partnerschaft mbB
(86) International application number: PCT/US2015/054066
(87) International publication number: WO 2016/057418

(56) References cited:
- WO-A1-2014/096153
- CN-A- 103 450 675
- CN-B- 102 796 372
- US-A1- 2005 209 383
- US-A1- 2012 252 951
- US-A1- 2012 279 764
- US-A1- 2013 172 466
- US-A1- 2014 166 925

## Description

### FIELD OF THE INVENTION

This invention concerns thermoplastic polymer compounds which are thermally conductive and capable of laser structuring and plasma metallization.

### BACKGROUND OF THE INVENTION

Any energized product in modern society is not ideally efficient. Therefore, the consumption of energy is accompanied by the emission of heat. Dissipation of heat from an energized product is a common industrial engineering consideration. Electronic products are particularly susceptible to excessive heat. Personal computers contain fans for keeping sensitive electronic parts at or near the ambient temperature by dissipating the heat by convection.

PCT Patent Publication WO2007149783 (Barber et al.) discloses the use of polyphenylene sulfide (PPS) and other thermoplastic resins in thermally conductive thermoplastic compounds.

Polymeric articles can be prepared for use in electronic circuitry whereby integrated circuit traces via direct metallization can be made in the surfaces of the polymeric article of any shape, using a process called "laser direct structuring." According to Ranft, et al., "LASER DIRECT STRUCTURING OF THERMALLY CONDUCTIVE POLYMERS: AN INNOVATIVE THERMAL MANAGEMENT APPROACH" (ANTEC, 2012), the laser direct structuring process (LDS) is an established technology for creating via direct metallization integrated circuit traces on three-dimensional thermoplastic parts, the so-called Molded Interconnect Devices (3D-MIDs). Starting in the late 1990s, the LDS technology started with a few commercial products in automotive and telecommunication applications. Recently, the largest market for this technology is the fabrication of integrated cell phone antennas, mostly situated in Asian countries.

Ranft et al. also report that another fast growing market and an important economical factor in the field of lighting technology is the exploding number of applications based on high brightness light emitting diodes (LEDs). Especially the improvements in luminous efficacy connected with the urgent need for energy conservation led to their increasing utilization in general lighting (residential, industrial, outdoor), traffic lights, automotive lighting, and other optoelectronic applications.

### SUMMARY OF THE INVENTION

The subject-matter of the present invention is defined in claims 1-9 as attached. What the art needs is a thermally conductive polymer compound which has thermal conductivity and also an ability to undergo laser structuring to produce integrated circuit traces via direct metallization on the laser-structured portions on surfaces of polymer articles made from the compound. Preferably, those polymer articles are printed circuit boards or LED lighting components, two polymer articles which need significant heat dissipation management. Because the polymer compound is thermally conductive, then the polymer articles, especially printed circuit boards or LED lighting components, are capable of functioning as a mechanism to dissipate heat from sources which generate heat, such as integrated circuits or electronic devices connected to integrated circuits.

The present invention has solved that problem by using one or more thermally conductive additives to provide thermal conductivity to the polymer article which has undergone laser structuring and plasma metallization. Moreover, the thermally conductive plastic article can be either electrically insulative or electrically conducting.

Thus, one aspect of the invention is a polymer article which has undergone laser structuring and plasma metallization, comprising a thermally conductive polymer compound comprising polymer resin capable of undergoing laser structuring and plasma metallization, a thermally conductive additive selected from the group consisting of thermally conductive, electrically insulative additives and thermally conductive, electrically conductive additives.

Preferably, the polymer resin is a capable of undergoing surface-mount technology (SMT) by non-lead reflow soldering.

Features of the invention will be explored below.

### BRIEF DESCRIPTION OF THE DRAWING

FIG. 1 is a photo of a polymer article made of thermally conductive polymer compound having been subjected to laser structuring to prepare the flat surface for an electronic circuit.
FIG. 2 is a photo of the polymer article of FIG. 1 having been subjected to plasma metallization to provide electronic circuitry.
FIG. 3 is a photo of the polymer article with a LED soldered to the electronic circuit.

### EMBODIMENTS OF THE INVENTION

### Thermoplastic Polymer Matrix

Any conventional thermoplastic polymer is a candidate to serve as the matrix for the compound if that polymer is capable of undergoing laser structuring and plasma metallization without adversely affecting its structural properties, such as durability, toughness, heat tolerance. Without undue experimentation, one of ordinary skill in the art can select a matrix based on considerations of cost, manufacturing technique, physical properties, chemical properties, etc. Non-limiting examples of suitable thermoplastic polymers are polyolefins, poly halo-olefins, polyamides, polyesters, polyurethanes, polycarbonates, polyarylenes (sulfides, ethers, etc.), and mixtures thereof. The polymers can be homopolymers or copolymers of any structure.

According to the present invention, among these many candidates, polyphenylene sulfide is used because of its durability, high temperature tolerance, existence of suitable thermal conductivity, and heat distortion temperature. Polyphenylene sulfides are polymers containing a phenyl moiety and one or more sulfides bonded thereto. Those skilled in the art will recognize the variety of commercially available polyphenylene sulfides are suitable for use in the present invention. Non-limiting examples of such commercially available polyphenylene sulfides ("PPS") include Ryton brand PPS powders in various grades from Chevron Phillips Chemical Co. of The Woodlands, Texas. Any of the patents in the literature known to those skilled in the art are appropriate for determining a suitable choice, without undue experimentation.

### Thermally Conductive Additives

### Thermally Conductive, Electrically Insulative Additives

### Boron Nitride

Thermally conductive, electrically insulative additive potentially useful for the compound is boron nitride, available commercially as cubic boron nitride or as hexagonal boron nitride. As is known in the art, hexagonal boron nitride provides a higher thermal conductivity than cubic boron nitride and therefore is preferred. Also hexagonal boron nitride assists in resulting high surface resistivity.

Presently preferred is boron nitride powder from ESK Ceramic GmbH of Kempten (Germany).

### Aluminosilicate

Another thermally conductive, electrically insulative additive potentially useful for the compound is an aluminosilicate. Presently preferred is Silatherm 1360-100 AST compound based on natural occurring aluminosilicate from Quarzwerke Gruppe of Frechen (Germany).

### Zinc Oxide

Another thermally conductive, electrically insulative additive potentially useful for the compound is zinc oxide. Presently preferred is NEIGE B zinc oxide from Umicore of Angleur (Belgium).

### Titanium Dioxide

Another thermally conductive, electrically insulative additive potentially useful for the compound is titanium dioxide, available commercially as rutile or as anatase.

Presently preferred is KRONOS 2220 titanium dioxide from Kronos of Dallas (USA).

While boron nitride, aluminosilicate, zinc oxide, and titanium dioxide have different thermal conductivity properties, it is possible that each alone could serve as the thermally conductive, electrically insulative additive dependent on usage rate in the compound. Among them, it has been found during experimentation of this invention that boron nitride alone or aluminosilicate alone can serve as that type of additive. It has also been found during experimentation of this invention that boron nitride, zinc oxide, and titanium dioxide can be used together, to serve as that type of thermally conductive, electrically insulative additive. Without undue experimentation, one having ordinary skill in the art can choose among these four thermally conductive, electrically insulative additives to use in various combinations and amounts to realize a thermally conductive, electrically insulative polymer compound which can undergo laser structuring and plasma metallization to make a polymer article of the present invention.

Other additives which are both thermally conductive and electrically insulative are candidates for use in this invention, as they may become identified by persons having ordinary skill in the art of making thermally conductive polymeric articles, such as thermally conductive printed circuit boards or LED lighting components

### Thermally Conductive, Electrically Conductive Additives

### Graphite

A thermally conductive, electrically conductive additive potentially useful for the compound is graphite, available commercially as natural or as synthetic.

Presently preferred is NFL98 natural hexagonal graphite from Edelgraphit of Bonn (Germany).

Other additives which are both thermally conductive and electrically conductive are candidates for use in this invention, as they may become identified by persons having ordinary skill in the art of making thermally conductive polymeric articles, such as pitch carbon fibers or carbon nano-tubes.

### Optional Filler Reinforcement

Structural integrity of polymer articles such as printed circuit boards, made of compounds of the present invention, can be enhanced by the use of reinforcing fillers. Preferably, those fillers are chemically inert, electrically insulative, and fibrous in shape.

Non-limiting examples of non-conductive reinforcing fillers are silica, glass fiber, aramid fiber, mineral fiber, and the like. Preferably glass fiber is used because of its availability and low cost compared to other types of fillers.

### Optional Other Additives

The compound of the present invention can include conventional plastics additives in an amount that is sufficient to obtain a desired processing or performance property for the compound. The amount should not be wasteful of the additive or detrimental to the processing or performance of the compound. Those skilled in the art of thermoplastics compounding, without undue experimentation but with reference to such treatises as Plastics Additives Database (2004) from Plastics Design Library (elsevier.com), can select from many different types of additives for inclusion into the compounds of the present invention.

Non-limiting examples of optional additives include adhesion promoters; biocides (antibacterials, fungicides, and mildewcides), anti-fogging agents; anti-static agents; bonding, blowing and foaming agents; dispersants; fillers and extenders, such as talc and glass fiber; flame retardants; smoke suppresants; impact modifiers; initiators; lubricants; micas; pigments, colorants and dyes; plasticizers, such as core/shell impact modifiers; processing aids; release agents; silanes, titanates and zirconates; slip and anti-blocking agents; stabilizers; stearates; ultraviolet light absorbers; viscosity regulators; waxes; catalyst deactivators, and combinations of them.

Of these various optional additives, metallic stearate have been found during experimentation for this invention to provide lubrication assistance during compounding and other processing operations involving converting the polymer compound from pellets to the final polymeric article. Therefore, according to the present invention said thermally conductive polymer compound comprises metallic stearate lubricant.

Table 1 shows acceptable, desirable, and preferable ranges of ingredients useful for polymeric articles containing thermally conductive, electrically insulative additives, all expressed in weight percent (wt. %) of the entire compound. The compound can comprise, consist essentially of, or consist of these ingredients. Any number between the ends of the ranges is also contemplated as an end of a range, such that all possible combinations are contemplated within the possibilities of Table 1 as candidate compounds for use in this invention.

| **Table 1** | | | |
|---|---|---|---|
| **Thermally Conductive, Electrically Insulative Polymer Articles** | | | |
| **Ingredient** | **Acceptable** | **Desirable** | **Preferable** |
| Polymer resin | 15-60 | 20-50 | 25-40 |
| Thermally conductive, electrically insulative additive(s) | 40-85 | 35-80 | 50-75 |
| Optional Thermally conductive, | 0-15 | 0-10 | 2-8 |
| electrically conductive additive(s) | | | |
| Optional Non-conductive fiber reinforcing agent | 0 - 15 | 5 - 12 | 8 - 10 |
| Optional calcium stearate lubricant | 0-0.5 | 0.1-0.4 | 0.1-0.3 |

Table 2 shows acceptable, desirable, and preferable ranges of ingredients useful for polymeric articles containing thermally conductive, electrically conductive additives, all expressed in weight percent (wt. %) of the entire compound. The compound can comprise, consist essentially of, or consist of these ingredients. Any number between the ends of the ranges is also contemplated as an end of a range, such that all possible combinations are contemplated within the possibilities of Table 2 as candidate compounds for use in this invention.

| **Table 2** | | | |
|---|---|---|---|
| **Thermally Conductive, Electrically Conductive Polymer Articles** | | | |
| **Ingredient** | **Acceptable** | **Desirable** | **Preferable** |
| Polymer resin | 30-70 | 35-60 | 30-50 |
| Thermally conductive, electrically conductive additive(s) | 30-70 | 35-65 | 40-60 |
| Optional Thermally conductive, electrically insulative additive(s) | 0 - 15 | 0 - 10 | 2 - 8 |
| Optional Non-conductive fiber reinforcing agent | 0 - 15 | 5 - 12 | 8 - 10 |
| Optional calcium stearate lubricant | 0-0.5 | 0.1-0.4 | 0.1-0.3 |

In both of the compounds, it is also contemplated that the opposite type of thermally conductive additive can optionally be added. The types of optional thermally conductive additive for the compound in Table 1 can be selected from the additive used for the compound in Table 2, and vice versa Thus, thermal conductivity can be enhanced with a different effect with respect to electrical conductivity or electrical insularity for the compounds of Tables 1 and 2, respectively.

### Processing

The preparation of compounds of the present invention is uncomplicated. The compound of the present can be made in batch or continuous operations.

Mixing in a continuous process typically occurs in a single or twin screw extruder that is elevated to a temperature that is sufficient to melt the polymer matrix with addition of other ingredients either at the head of the extruder or downstream in the extruder. Extruder speeds can range from about 50 to about 500 revolutions per minute (rpm), and preferably from about 100 to about 300 rpm. Typically, the output from the extruder is pelletized for later extrusion or molding into polymeric articles.

Mixing in a batch process typically occurs in a Banbury mixer that is capable of operating at a temperature that is sufficient to melt the polymer matrix to permit addition of the solid ingredient additives. The mixing speeds range from 60 to 1000 rpm. Also, the output from the mixer is chopped into smaller sizes for later extrusion or molding into polymeric articles.

Subsequent extrusion or molding techniques are well known to those skilled in the art of thermoplastics polymer engineering. Without undue experimentation but with such references as "Extrusion, The Definitive Processing Guide and Handbook"; "Handbook of Molded Part Shrinkage and Warpage"; "Specialized Molding Techniques"; "Rotational Molding Technology"; and "Handbook of Mold, Tool and Die Repair Welding", all published by Plastics Design Library (elsevier.com), one can make articles of any conceivable shape and appearance using compounds of the present invention.

### USEFULNESS OF THE INVENTION

Compounds of the present invention can dissipate heat quite efficiently, making them suitable for extruded, molded, calendered, thermoformed, or 3D-printed articles designed to contact a heated object and conduct that heat away from that object or contact a heated object and conduct that heat toward a second object that needs heat also. Either way, the compounds of the present invention can transport heat away from that source, whether to distribute to a remote location from that object (a radiator in a residential room) or to dissipate to a remote location from that object (a heat sink).

With the capability of laser structuring, plasma metallization and, preferably, surface-mount technology (SMT) by non-lead reflow soldering, the polymer article (however it may be formed) can thereafter undergo laser processing and plasma metallization to provide circuitry traces for the article to become part of electronic circuitry. Other electronic components can then be soldered to the electronic circuitry.

An example of laser processing and plasma metallization methods is disclosed in PCT Patent Publication WO 2014/114707 (Plasma Innovations GmbH).

One industry which needs management and dissipation of heat is the lighting industry, especially lighting produced by light emitting diodes (LEDs) as opposed to filamented electrical lamps. LEDs are sensitive in performance in the presence of temperature, as are the electronics nearby or contiguous to a lighted LED. Therefore, a preferred molded article is a LED lighting components or other electronic part. With the capability of laser structuring and plasma metallization, the LED lighting component or other electronic part itself can have electronic circuitry formed on its surface(s).

The physical properties of the polymer matrix determine the suitability of the compound for specific polymer engineering purposes; the use of the thermally conductive additive (either electrically insulative or electrically conductive) imparts thermally conductivity where none or only a little thermal conductivity previously existed in the polymer matrix; and the optional non-conductive filler can add reinforcement to the physical properties of the polymer matrix.

The compounds can be used in several types of electronic circuitry applications within such devices as personal computers, tablet computers, smart phones, global positioning system devices, medical devices, RFID transmitters and receivers, and electronics generally in the health care, automotive, construction, aerospace, and other industries. More specifically, LED lighting components, printed circuit boards, antennas, and other electronic components or parts can benefit from the versatility of thermally conductive polymeric articles, whether electrically insulative or electrically conductive, depending on user choice.

Examples provide successful testing results.

### EXAMPLES

### Examples 1-4

Table 3 shows the list of ingredients and the recipes.

| **Table 3** | | | | |
|---|---|---|---|---|
| Ingredients in Weight Percent | Example 1 | Example 2 | Example 3 | Example 4 |
| PPS QA280N / PPS PR26 Polyphenylene Sulfide (Chevron Phillips) | 39.80% | 29.90% | 25.00% | 39.80% |
| Cooling Filler Platelets 015 Boron nitride powder (ESK Ceramics) | 50.00% | 5.00% | | |
| Zinc Oxide NEIGE B Zinc oxide (ZnO) (Umicore) | | 35.00% | | |
| KRONOS 2220 Titanium dioxide (TiO₂) (Kronos) | | 19.90% | | |
| Silatherm 1360-100 AST Compound based on natural occuring Aluminosilicate (Quarzwerke) | | | 75.00% | |
| Edelgraphit NFL98 Natural graphite (hexagonal) (Edelgraphit) | | | | 50.00% |
| Chop Vantage HP 3786 FDA PBT+PC+PET+PPS Chopped fiber, E-glass, 10 micron diameter, 4.5mm length (PPG) | 10.00% | 10.00% | | 10.00% |
| METALLIC STEARATES [Calcium] FLAKES Long-chain fatty acid with calcium) (Baerlocher) | 0.20% | 0.20% | | 0.20% |

Examples 1-4 were prepared by melt-mixing extrusion using a twin-screw extruder operating at temperatures above the melting point of the polyphenylene sulfide. The extrudate was pelletized for subsequent injection molding done at RF-Plast GmbH with laser structuring and plasma metallization processing done by Plasma-Innovations GmbH.

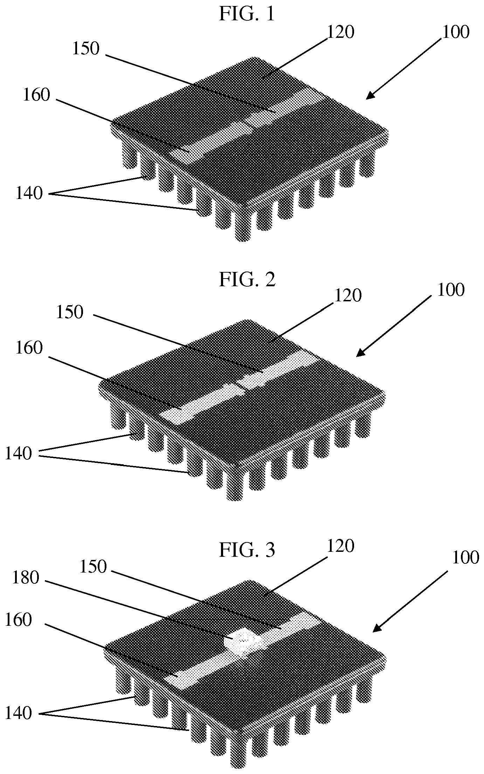

Briefly, the polymer compounds of Examples 1-3 were injection molded into a part 100 having a flat surface 120 of approximately 3 cm by 3 cm, as seen in FIG. 1. The opposing surface comprises an array of posts 140 for dissipation of heat. Then a mask was deposited on the flat surface. Then the masked flat surface was subjected to laser structuring of specific areas 150 and 160 of the flat surface, also as seen in FIG 1. Then a plasma coating of copper was adhered to those specific areas 150 and 160 of the flat surface, as seen in FIG 2. Then, as seen in FIG 3, a LED 180 was soldered to the copper coated specific areas of the flat surface and connected to a power source (not shown) to prove that an electrical circuit was established on those specific areas 150 and 160 of the flat surface.

Example 4 was tested in the same manner as Examples 1-3, except that between the molding step and the masking step, a ceramic layer was adhered to the entire flat surface by plasma deposition of aluminum oxide. An electrical circuit was also established and proven by use of the LED.

Plasma Innovations GmbH is known in the art of structured metallization of plastics, capable of providing a metallization process having a layer of between about 5 and about 50 micrometers, often of copper because of its cost and conductivity. The plasma coating process uses a high energy arc discharge operating at 10,000°C which directs the ionized plasma to the surface to be metalized. Powders ranging from 1 to 40 micrometers in size can be used in the plasma metallization process.

One of the advantages of the polymer compounds described above is that a polymeric article formed from such compounds not only can be laser structured and plasma metalized into a specific and precise electronic circuit, but also such compounds have thermal conductivity to dissipate heat from heat-sensitive electronic circuitry and devices.

The thermal conductivity of the Examples 1-4 had a through plane thermal conductivity ranging from about 1 W/m.K to about 4 W/m.K measured by C-Therm TCi™ technology on molded samples having a thickness of 4 mm.

The invention is not limited to the above embodiments. The claims follow.

## Claims

1. A polymer article which has undergone laser structuring and plasma metallization, comprising:
a thermally conductive polymer compound comprising:
(a) polyphenylene sulfide;
(b) a thermally conductive additive selected from the group consisting of thermally conductive, electrically insulative additives and thermally conductive, electrically conductive additives; and
(c) metallic stearate lubricant.

2. The polymer article of Claim 1, wherein the thermally conductive, electrically insulative additive is selected from the group consisting of boron nitride, aluminosilicate, zinc oxide, titanium dioxide, or a combination of them, and wherein the thermally conductive, electrically conductive additive is graphite.

3. The polymer article of Claim 1 or Claim 2, further comprising an additive selected from the group consisting of adhesion promoters; biocides; anti-fogging agents; anti-static agents; bonding, blowing and foaming agents; dispersants; fillers and extenders; flame retardants; glass fibers; smoke suppressants; impact modifiers; initiators; lubricants; micas; pigments, colorants and dyes; plasticizers; processing aids; release agents; silanes, titanates and zirconates; slip and anti-blocking agents; stabilizers; stearates; ultraviolet light absorbers; viscosity regulators; waxes; catalyst deactivators, and combinations of them.

4. The polymer article of any of Claims 1 to 3, wherein the compound is electrically insulative and has ingredients in amounts expressed in weight percent:
| | |
|---|---|
| Polyphenylene sulfide | at least 15 |
| Thermally conductive, electrically insulative additive(s) | at least 40 |
| Optional thermally conductive, electrically conductive additive(s) | 0-15 |
| Optional Non-conductive fiber reinforcing agent | 0-15 |
| Calcium stearate lubricant | 0.1-0.5. |

5. The polymer article of any of Claims 1 to 3, wherein the compound is electrically conductive and has ingredients in amounts expressed in weight percent:
| | |
|---|---|
| Polyphenylene sulfide | at least 30 |
| Thermally conductive, electrically conductive additive(s) | at least 30 |
| Optional Thermally conductive, electrically insulative additive(s) | 0-15 |
| Optional Non-conductive fiber reinforcing agent | 0-15 |
| Calcium stearate lubricant | 0.1-0.5. |

6. The polymer article of any of Claims 1-5, wherein the article is extruded, molded, calendered, thermoformed, or 3D-printed.

7. The polymer article of any of Claims 1-5, wherein the article is a printed circuit board or a LED lighting component.

8. A method of making the polymer article of Claim 1, wherein the compound is molded into a shape designed to contact a heated object and conduct that heat away from that object or contact a heated object and conduct that heat toward a second object that needs heat also, wherein the article has undergone laser structuring and plasma metallization to provide integrated circuitry to the article.

9. The method of Claim 8, wherein the polymer article has also undergone surface-mount technology by non-lead reflow soldering.

## Patentansprüche

1. Polymerartikel, der einer Laserstrukturierung und Plasmametallisierung unterzogen wurde, umfassend:
ein wärmeleitendes Polymercompound, umfassend:
(a) Polyphenylensulfid;
(b) ein wärmeleitendes Additiv, ausgewählt aus der Gruppe bestehend aus wärmeleitenden, elektrisch isolierenden Additiven und wärmeleitenden, elektrisch leitenden Additiven; und
(c) Metallstearat-Gleitmittel.

2. Polymerartikel nach Anspruch 1, wobei das wärmeleitende, elektrisch isolierende Additiv ausgewählt ist aus der Gruppe bestehend aus Bornitrid, Aluminosilicat, Zinkoxid, Titandioxid oder einer Kombination davon, und wobei das wärmeleitende, elektrisch leitende Additiv Graphit ist.

3. Polymerartikel nach Anspruch 1 oder Anspruch 2, ferner umfassend ein Additiv ausgewählt aus der Gruppe bestehend aus Haftvermittlern; Bioziden; Antitrübungsmitteln; Antistatikmitteln; Binde-, Treib- und Schäummitteln; Dispergiermittel; Füllstoffen und Extendern; Flammschutzmitteln; Glasfasern; Rauchunterdrückern; Schlagzähmodifikatoren; Initiatoren; Gleitmitteln; Glimmer; Pigmenten, Färbemitteln und Farbstoffen; Weichmachern; Verarbeitungshilfsstoffen; Trennmitteln; Silanen, Titanaten und Zirkonaten; Gleit- und Antiblockmitteln; Stabilisatoren; Stearaten; Absorbern für ultraviolettes Licht; Viskositätsreglern; Wachsen; Katalysatordeaktivatoren und Kombinationen davon.

4. Polymerartikel nach einem der Ansprüche 1 bis 3, wobei das Compound elektrisch isolierend ist und Bestandteile in Mengen aufweist, ausgedrückt in Gewichtsprozent:
| | |
|---|---|
| Polyphenylensulfid | mindestens 15 |
| Wärmeleitende(s), elektrisch isolierende(s) Additiv(e) | mindestens 40 |
| Optionale(s) wärmeleitende(s), elektrisch leitende(s) Additiv(e) | 0 - 15 |
| Optionales nicht leitendes Faserverstärkungsm ittel | 0 - 15 |
| Calciumstearat-Gleitmittel | 0,1 - 0,5. |

5. Polymerartikel nach einem der Ansprüche 1 bis 3, wobei das Compound elektrisch leitend ist und Bestandteile in Mengen aufweist, ausgedrückt in Gewichtsprozent:
| | |
|---|---|
| Polyphenylensulfid | mindestens 30 |
| Wärmeleitende(s), elektrisch leitende(s) Additiv(e) | mindestens 30 |
| Optionale(s) wärmeleitende(s), elektrisch isolierende(s) Additiv(e) | 0 - 15 |
| Optionales nicht leitendes Faserverstärkungsm ittel | 0 - 15 |
| Calciumstearat-Gleitmittel | 0,1 - 0,5. |

6. Polymerartikel nach einem der Ansprüche 1 bis 5, wobei der Artikel extrudiert, geformt, kalandriert, thermogeformt oder 3D-gedruckt ist.

7. Polymerartikel nach einem der Ansprüche 1 bis 5, wobei der Artikel eine Leiterplatte oder eine LED-Beleuchtungskomponente ist.

8. Verfahren zur Herstellung des Polymerartikels gemäß Anspruch 1, wobei das Compound in eine Gestalt geformt wird, die dazu ausgelegt ist, ein erwärmtes Objekt zu kontaktieren und diese Wärme von diesem Objekt abzuleiten oder ein erwärmtes Objekt zu kontaktieren und diese Wärme zu einem zweiten Objekt zu leiten, das ebenfalls Wärme benötigt, wobei der Artikel einer Laserstrukturierung und Plasmametallisierung unterzogen wurde, um dem Artikel eine integrierte Schaltung bereitzustellen.

9. Verfahren nach Anspruch 8, wobei der Polymerartikel auch einer Oberflächenmontagetechnologie durch bleifreies Reflow-Löten unterzogen wurde.

## Revendications

1. Article polymère ayant subi une structuration au laser et une métallisation au plasma, comprenant :
un composé polymère thermoconducteur comprenant :
(a) du sulfure de polyphénylène ;
(b) un additif thermoconducteur choisi parmi le groupe se composant d'additifs thermoconducteurs électroisolants et des additifs thermoconducteurs électroconducteurs ; et
(c) un lubrifiant de stéarate métallique.

2. Article polymère selon la revendication 1, dans lequel l'additif thermoconducteur électroisolant est choisi parmi le groupe se composant de nitrure de bore, d'aluminosilicate, d'oxyde de zinc, de dioxyde de titane, ou une combinaison de ceux-ci, et dans lequel l'additif thermoconducteur électroconducteur est du graphite.

3. Article polymère selon la revendication 1 ou la revendication 2, comprenant en outre un additif choisi parmi le groupe se composant de promoteurs d'adhésion ; biocides ; agents anti-buée ; agents antistatiques ; agents liants, gonflants et moussants ; dispersants ; charges et diluants ; ignifugeants ; fibres de verre ; suppresseurs de fumée ; modificateurs d'impact ; initiateurs ; lubrifiants ; micas ; pigments , colorants et teintures ; plastifiants ; auxiliaires technologiques ; agents de démoulage ; silanes, titanates et zirconates ; agents antidérapants et anti-bloquants ; stabilisateurs ; stéarates ; absorbeurs de lumière ultraviolette ; régulateurs de viscosité ; cires ; désactivateurs de catalyseurs et des combinaisons de ceux-ci.

4. Article polymère selon l'une quelconque des revendications 1 à 3, dans lequel le composé est électroisolant et contient des composants en des quantités exprimées en pourcentage en poids :
| | |
|---|---|
| Sulfure de polyphénylène | au moins 15 |
| Additif(s) thermoconducteur(s) électroisolant(s) | au moins 40 |
| Additif(s) thermoconducteur(s) électroconducteur(s) facultatifs | 0 à 15 |
| Agent de renforcement de fibres non conducteur facultatif | 0 à 15 |
| Lubrifiant de stéarate de calcium | 0,1 à 0,5 |

5. Article polymère selon l'une quelconque des revendications 1 à 3, dans lequel le composé est électroconducteur et contient des composants en des quantités exprimées en pourcentage en poids :
| | |
|---|---|
| Sulfure de polyphénylène | au moins 30 |
| Additif(s) thermoconducteur(s) électroconducteur(s) | au moins 30 |
| Additif(s) thermoconducteur(s) électroisolant(s) facultatif(s) | 0 à 15 |
| Agent de renforcement de fibres non conducteur facultatif | 0 à 15 |
| Lubrifiant de stéarate de calcium | 0,1 à 0,5. |

6. Article polymère selon l'une quelconque des revendications 1 à 5, dans lequel l'article est extrudé, moulé, calandré, thermoformé ou imprimé en 3D.

7. Article polymère selon l'une quelconque des revendications 1 à 5, dans lequel l'article est une carte de circuit imprimé ou un élément d'éclairage à DEL.

8. Procédé de fabrication de l'article polymère selon la revendication 1, dans lequel le composé est moulé en une forme conçue pour entrer en contact avec un objet chauffé et éloigner cette chaleur de cet objet ou entrer en contact avec un objet chauffé et diriger cette chaleur vers un deuxième objet qui a également besoin de chaleur, dans lequel l'article a subi une structuration au laser et une métallisation au plasma pour fournir un circuit intégré à l'article.

9. Procédé selon la revendication 8, dans lequel l'article polymère a également subi une technologie de montage en surface par soudage par refusion sans plomb.
